# EUROPEAN PATENT APPLICATION

(11) **EP 1 489 890 A1**
(43) Date of publication of application: **22.12.2004**
(21) Application number: 03744997.2
(22) Date of filing: 19.03.2003
(51) Int. Cl.: H05B 33/04, H05B 33/10, H05B 33/14

(54) **ORGANIC ELECTROLUMINESCENCE DISPLAY PANEL AND METHOD FOR MANUFACTURING THE SAME**

(30) Priority: 25.03.2002 JP 2002082510
(71) Applicant: Pioneer Corporation, Tokyo 153-8654 (JP)
(72) Inventor: SUGIMOTO, Akira, Tsurugashima-shi, Saitama 350-2288 (JP); YOSHIDA, Ayako, Tsurugashima-shi, Saitama 350-2288 (JP); FUJIMURA, Soh, Tsurugashima-shi, Saitama 350-2288 (JP)
(74) Representative: Manitz, Finsterwald & Partner GbR
(86) International application number: PCT/JP2003/003312
(87) International publication number: WO 2003/081955

(57) **Abstract**

An organic electroluminescent
an organic electroluminescent display panel includes organic electroluminescent elements and
a resin substrate supporting the organic electroluminescent elements. Each organic electroluminescent element has first and second display electrodes and one or more organic functional layers of organic compounds sandwiched and layered between the first and second display electrodes, the organic functional layers including a light-emitting layer. The display panel includes an inclusion-inorganic-barrier laminate provided at least between the organic electroluminescent elements and the resin substrate and having a high-molecular compound film embedded within the inclusion-inorganic-barrier-laminate, in a form of being in contact with the organic electroluminescent elements.

## Description

### TECHNICAL FIELD

The present invention relates to an organic electroluminescent element (hereinafter referred to as an organic EL element) comprising one or more organic thin films (hereinafter referred to as an organic functional layer) including a light-emitting layer consisting of organic compound material which exhibits electroluminescence when electrical current is injected thereto. More particularly, the present invention relates to an electroluminescent display panel (hereinafter referred to as organic EL display panel) with one or more organic EL elements formed on a substrate.

### BACKGROUND ART

The organic EL element fundamentally comprises an anode and a cathode with one or more organic functional layers layered between them. In the light-emitting layer of the organic EL element, an electron and a hole injected from both electrodes recombine with each other to form an exciton. When the exciton changes its state from an excited state to a basic state, it emits light. For example, an organic EL element has an anodic transparent electrode, an organic functional layer, and a cathodic metal electrode, which are sequentially deposited on a transparent substrate so as to emit light through the transparent substrate side. The organic functional layer can be formed in a laminate form of a single light-emitting layer, or of a three-layer structure which includes an organic hole transport layer, a light-emitting layer and an organic electron transport layer, or of a two-layer structure which includes an organic hole transport layer and a light-emitting layer. At least one of an electron injection layer, a hole injection layer and a carrier block layer may be inserted in between suitable layers of the above-mentioned layered structures and both electrodes.

For example, an organic EL display panel of a matrix type or having a predetermined light-emitting pattern is conventionally known as employs a plurality of organic EL elements. It has been suggested to employ a synthetic resin or plastics as the substrate of the organic EL display panel.

When this organic EL element is exposed to the atmosphere, it is easily degraded by water, gasses such as oxygen, and some type of molecule in the operating environment. In particular, the properties of the organic EL element using a plastic film substrate deteriorate markedly, and the luminescent properties, such as brightness and color, also deteriorate. To prevent such adverse influences, there is a supposed method for shutting out water or the like penetrating the plastic film substrate by using a barrier film made of an inorganic material with which the surface of the plastic substrate. There is however a problem of generation of pinholes in the coatings of the inorganic barrier film. The pinholes penetrating the inorganic barrier film are caused by roughness or contamination on the underlayer before the film-deposition. In addition, the pinholes of the inorganic barrier film are generated during the film-deposition irrespective of the underlayer. It is difficult to perfectly restrain the generation of pinholes of the inorganic barrier film in the manufacturing process.

When the pinholes exist in the inorganic barrier film, water or the like invading the organic EL element brings about deterioration in properties thereof.

### DISCLOSURE OF INVENTION

It is an object of the present invention to provide an organic EL element and an organic EL display panel having resistant properties against degradation of luminance caused by water or the like.

According to the present invention, there is provided an organic electroluminescent display panel comprising:
one or more organic electroluminescent elements each having first and second display electrodes and one or more organic functional layers of organic compounds sandwiched and layered between said first and second display electrodes, the organic functional layers including a light-emitting layer; and
a resin substrate supporting the organic electroluminescent elements;
an inclusion-inorganic-barrier laminate provided at least between said organic electroluminescent elements and said resin substrate and having a high-molecular compound film embedded within the inclusion-inorganic-barrier-laminate, in a form of being in contact with said organic electroluminescent elements.

In the organic electroluminescent display panel according to the invention, said inclusion-inorganic-barrier laminate is made of silicon oxynitride.

In the organic electroluminescent display panel according to the invention, said inclusion-inorganic-barrier laminate is formed by a sputter deposition process.

In the organic electroluminescent display panel according to the invention, said high-molecular compound film is formed by a photolithography process or a printing process.

The organic electroluminescent display panel according to the invention further comprises a sealing film for covering said organic electroluminescent elements from a rear side thereof.

In the organic electroluminescent display panel according to the invention, said sealing film is an inorganic passivation film, and said organic electroluminescent element is entirely and hermetically covered with said inclusion-inorganic-barrier laminate and said sealing film.

In the organic electroluminescent display panel according to the invention, said inclusion-inorganic-barrier laminate comprises one or more inorganic-barrier film pairs sandwiching said high-molecular compound film in a thickness direction thereof.

Furthermore, according to the present invention, there is provided a method of manufacturing an organic electroluminescent display panel comprising one or more organic electroluminescent elements and a resin substrate supporting the organic electroluminescent elements, comprising the steps of:
forming a first inorganic barrier film having an area so as to cover the resin substrate;
forming, on or over said first inorganic barrier film, a high-molecular compound film having an area smaller than that of said first inorganic barrier film;
forming, on or over said high-molecular compound film, a second inorganic barrier film having an area larger than that of said high-molecular compound film;
forming, on or over said second inorganic barrier film, one or more organic electroluminescent elements, each having first and second display electrodes and one or more organic functional layers of organic compounds sandwiched and layered between said first and second display electrodes, the organic functional layers including a light-emitting layer.

In the manufacturing method of the organic electroluminescent display panel according to the invention, said first and second inorganic barrier films are made of silicon oxynitride.

In the manufacturing method of the organic electroluminescent display panel according to the invention, said first and second inorganic barrier films are formed by a sputter deposition process.

In the manufacturing method of the organic electroluminescent display panel according to the invention, said high-molecular compound film is formed by a photolithography process or a printing process.

### BRIEF DESCRIPTION OF DRAWINGS

Fig. 1 is a schematic cross section view of an organic EL element according to an embodiment of the present invention.
Figs. 2-5 are schematic cross section views each showing a substrate in the manufacturing process of an organic EL display panel according to the present invention.
Figs. 6-8 are schematic cross section views each showing an organic EL element according to another embodiment of the present invention.
Fig. 9 is a partial enlarged rear view of an organic EL display panel comprising a plurality of organic EL elements according to another embodiment of the present invention.

### DETAILED DESCRIPTION OF THE INVENTION

Exemplary embodiments of the present invention are described below with reference to the accompanying drawings.

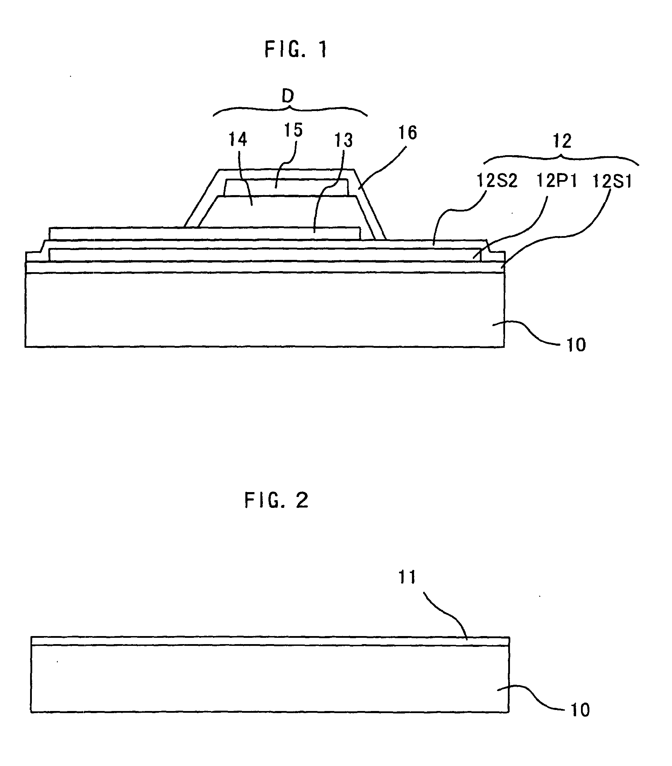

As shown in Fig. 1, the organic EL element according to this embodiment includes a resin substrate 10, the surface of which is covered with an inclusion-inorganic-barrier laminate 12 which compresses a high-molecular compound film 12P1 embedded between first and second inorganic barrier films 12S1 and 12S2. Deposited sequentially on the resin substrate 10 are a first display electrode 13 (e.g., anode of a transparent electrode), one or more organic functional layers 14 including a light-emitting layer formed of an organic compound, and a second display electrode 15 (e.g., cathode of a metallic electrode). The organic EL element has also a sealing film 16 for covering the second display electrode 15 from the rear surface thereof. A further the high-molecular compound film may be provided on a back surface of the resin substrate 10 which is not in contact with the organic EL element beneath the first inorganic barrier film 12S1.

The first and second inorganic barrier film 12S1 and 12S2 are formed of silicon oxynitride or silicon oxide for example. These inorganic barrier films are deposited by a sputtering method. The high-molecular compound film 12P1 is formed by a printing process. For the synthetic resin substrate, a film material such as polyethylene terephthalate, polyethylene-2, 6-naphthalate, polycarbonate, polysulfone, polyethersulfone, polyether ether ketone, polyphenoxyether, polyalylate, fluororesin, polypropylene or the like can be used. For the high-molecular compound film 12P1, a material such as ultraviolet ray (UV) setting resin, thermosetting resin or the like can be used.

It is preferable that the surfaces of the resin substrate 10 covered with the inclusion-inorganic-barrier laminate 12 include at least a surface in contact with the organic EL element, a surface between organic EL elements, a surface around the organic EL element, and a surface of the reverse side of the surface in contact with the organic EL element. This configuration is required to prevent the entry of moisture into the organic functional layer. in a manufacturing process for the organic EL element, the first display electrode 13 consisting of indium-tin oxide (ITO) is evaporated or sputtered on the substrate 10 to form a thin film. The organic functional layers_ or laminate 14 is formed thereon by evaporating a hole injection layer consisting of copper phthalocyanine, a hole transport layer consisting of TPD (triphenylamine derivative), a light-emitting layer consisting of Alq3 (aluminum chelate complex), and an electron injection layer consisting of Li₂O (lithium oxide) successively. In addition, the second display electrode 15 made of aluminum is formed by evaporation in such a manner that it faces the electrode pattern of the transparent electrode 13.

According to the invention, at least one inclusion-inorganic-barrier laminate 12 is provided at least between the organic EL element and the resin substrate in the resin substrate used for the organic EL element. In addition, the high-molecular compound is sandwiched between the pair of the inorganic barrier film in each inclusion-inorganic-barrier laminate. In other words, the inorganic barrier films and the high-molecular compound films are alternately layered one by one. The inorganic barrier film is formed at the upper-most layer of the resin substrate (the contact side with the organic EL element), that is, at least at the organic EL element side beneath the inorganic barrier film, the internal high-molecular compound film is formed to be embedded in the pair inorganic barrier films to keep within the inorganic barrier films.

### [EMBODIMENTS]

To obtain organic EL elements with moisture resistant, several samples of resin substrates for use such organic EL elements were prepared. First, experimental substrates each having a further high-molecular compound film between the first inorganic barrier film and the resin substrate were prepared.

For example, as shown in Fig. 2, a resin substrate 10 made of polycarbonate for a base was coated with a fluid UV setting resin and then was illuminated with ultraviolet rays to harden the resin, so that the further high-molecular compound film 11 made of the UV setting resin and functioning a buffer layer was deposited thereon.

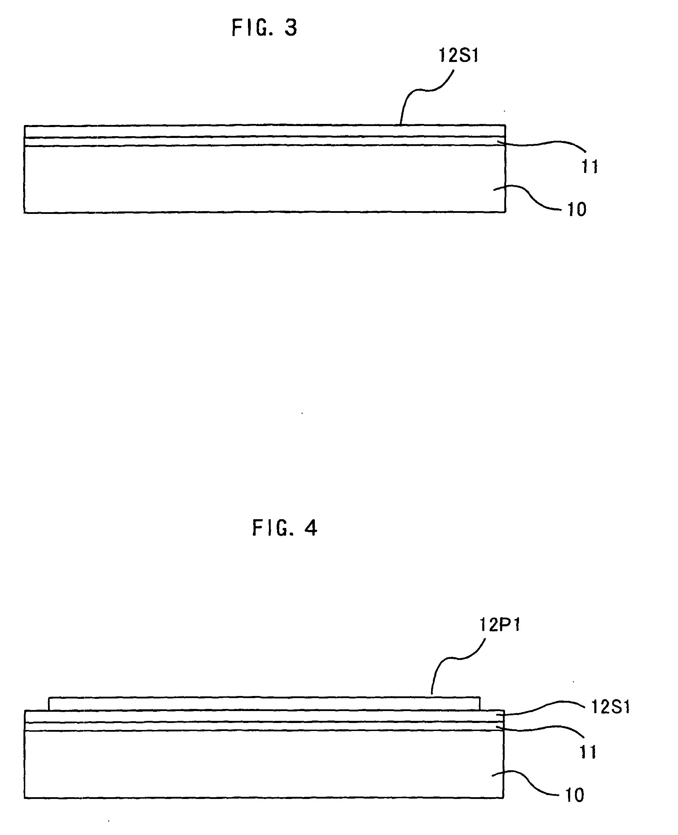

Next, as shown in Fig. 3, a first inorganic barrier film 12S1 of silicon oxynitride film was deposited on the further high-molecular compound film 11 through a RF sputtering deposition. In this way, experimental substrates were prepared.

After that, three sorts of organic EL elements were fabricated using the experimental substrates.

As Comparative 1, the organic EL element D of Fig. 1 was formed on the first inorganic barrier film 12S1 of the experimental substrate.

As Comparative 2, the first inorganic barrier film 12S1 of the experimental substrate was coated with a fluid UV setting resin as a whole and then was illuminated with ultraviolet rays to harden the resin as a high-molecular compound film. Then, a second inorganic barrier film of silicon oxynitride film was deposited on the high-molecular compound film by RF sputtering. After that, the organic EL element D of Fig. 1 was fabricated on the second inorganic barrier film. In the Comparative 2, the high-molecular compound film sandwiched between the firs and the second inorganic barrier films was exposed to the outside.

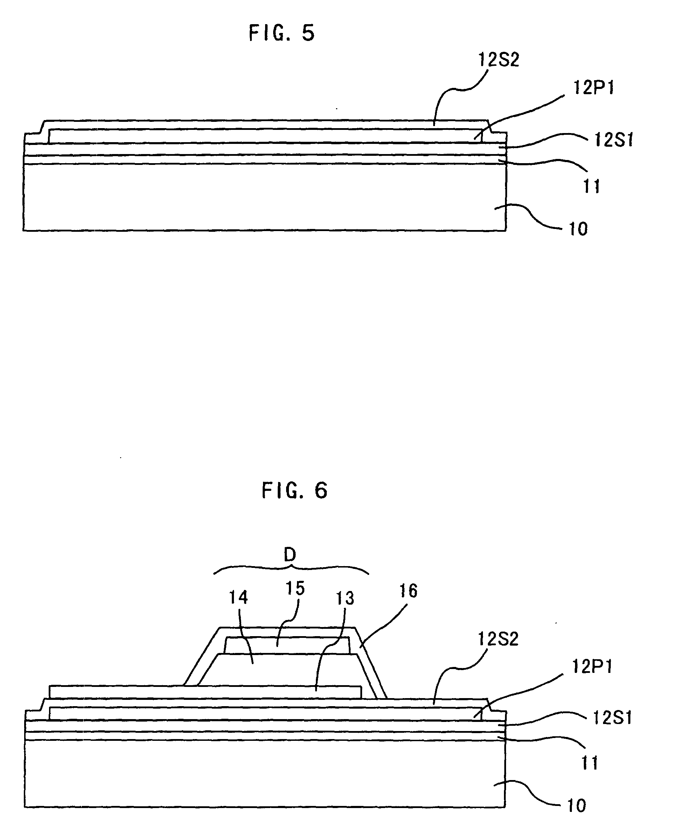

As one embodiment, as shown in Fig. 4, a high-molecular compound film 12P1 of an UV setting resin was patterned on the first inorganic barrier film 12S1 of the experimental substrate and then hardened in such a manner that the high-molecular compound film 12P1 having an area smaller than that of the first inorganic barrier film 12S1. As a result, the high-molecular compound film 12P1 was embedded without exposing the edge thereof to the outside. After that, as shown in Fig. 5, a second inorganic barrier film 12S2 of silicon oxynitride was deposited on the high-molecular compound film 12P1 and the first inorganic barrier film 12S1. After that, a first display electrode 13 (i.e., anode of a transparent electrode), one or more organic functional layers 14 including a light-emitting layer of an organic compound or more, a second display electrode 15 (i.e., cathode of a metallic electrode) and a sealing film 16 for sealing them were sequentially formed on the second inorganic barrier film 12S2. As a result, as shown in Fig. 6, the embodiments of the organic EL elements D were fabricated.

The organic EL elements prepared as described above were driven to emit light and observed from the direction of output light. These organic EL elements were kept at 60 °C for 500 hours at 95% relative humidity, and then observed again to check the states of light emission and compare in size of luminance defects. The resultant of experiences exhibited a relationship in the size of luminance defects as follows: (Comparative 1) > (Comparative 2) > (Embodiment).

As seen from the resultant, it was confirmed that, in the Embodiment, pinholes existing the first inorganic barrier film 12S1 allow water to enter a little, but such water is diffused within the high-molecular compound film 12P1, so that such diffused water hardly reached at possible pinholes of the second inorganic barrier film 12S2.

The embodiment of the invention shown in Fig. 6 has a structure of the buffer layer (high-molecular compound film) / the first inorganic barrier film / the embedded high-molecular compound film / the second inorganic barrier film. As shown in Fig. 1, the buffer layer (high-molecular compound film) 11 may be omitted if it secured that the first inorganic barrier film 12S1 has close adherence to the resin substrate 10.

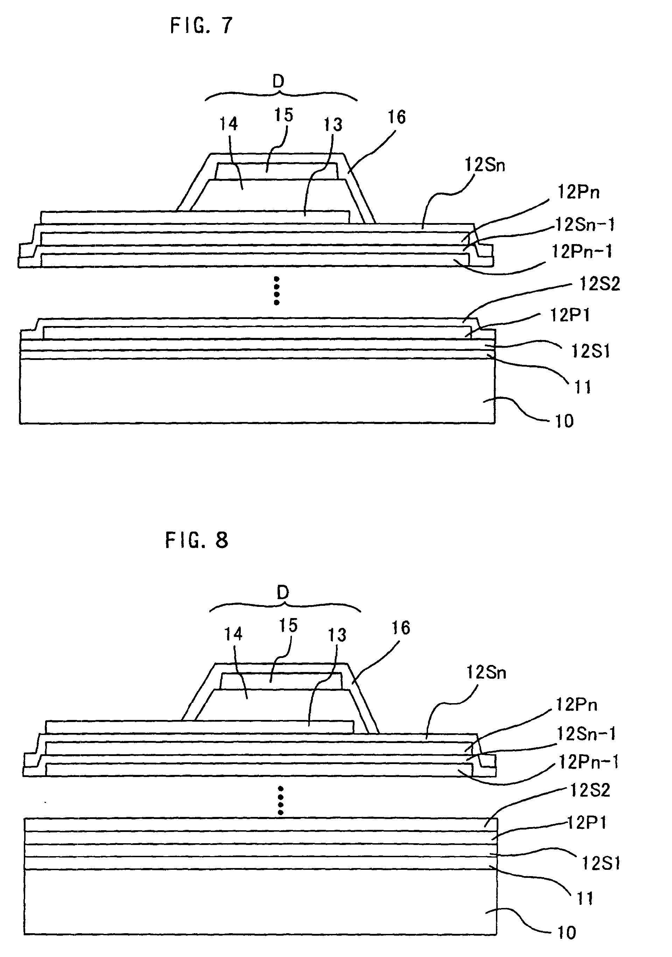

There are other embodiments of the invention, three layers or more of the inorganic barrier films e.g., n layers (n = integer) may be layered, if necessary. For example, as shown in Fig. 7, on the buffer layer (high-molecular compound film) 11 formed on the resin substrate 10, sequentially layered are, the first inorganic barrier film 12S1, the 1st high-molecular compound film 12P1 embedded, the second inorganic barrier film 12S2, ··· the n-1-th high-molecular compound film 12Pn-1 embedded, the n-1-th inorganic barrier film 12Sn-1, the n-th high-molecular compound film 12Pn embedded, the n-th inorganic barrier film 12Sn, on which the organic EL element D of the embodiment may be formed. In addition, as shown in Fig. 8, on the buffer layer (high-molecular compound film) 11 formed on the resin substrate 10, sequentially layered are, the first inorganic barrier film 12S1, the 1st high-molecular compound film 12P1 wholly formed, the second inorganic barrier film 12S2 wholly formed, ··· the n-1-th high-molecular compound film 12Pn-1 embedded, the n-1-th inorganic barrier film 12Sn-1, the n-th high-molecular compound film 12Pn embedded, the n-th inorganic barrier film 12Sn, on which the organic EL element D of the embodiment may be similarly formed. In every case, the high-molecular compound film is formed between the inorganic barrier films and, at the most upper, the inorganic barrier film (the n-th inorganic barrier film 12Sn) is formed. As seen from the figures, each of the high-molecular compound film 12P has an optional pattern or shape, i.e., it is patterned even at a lower portion (Fig. 7), but not (Fig. 8), the most upper (n-th layer) high-molecular compound film is required to be patterned as a smaller area so that the edge of the high-molecular compound film is not exposed to the outside, because of prevention of water invasion.

The embodiment mentioned above employs a printing method for patterning the high-molecular compound film. Moreover, a photolithography process may be used for such patterning in the invention.

In the invention, a plurality of the inorganic barrier films are layered in which the high-molecular compound film is inserted between the inorganic barrier film and, the edge of the high-molecular compound film the nearest to the organic functional layer of the organic EL element is not exposed to the outside. Therefore, such structure of the element achieves the nearly perfect shut out of the invasion path of water entering through possible defects or pinholes existing the inorganic barrier film. Consequently, the invention can provide a highly reliability to the organic EL element.

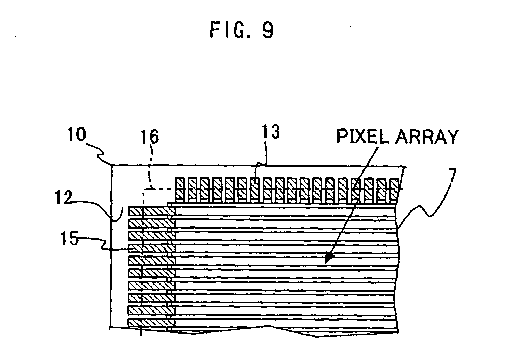

Fig. 9 is an enlarged partial rear view illustrating an organic EL display panel including a plurality of organic EL elements according to another embodiment. The organic EL display panel includes a plurality of organic EL elements disposed in a matrix on the PC resin substrate 10, the entirety of which is covered with an inclusion-inorganic-barrier laminate or more. On top of the film of silicon oxynitride, sequentially layered are a row electrode 13 (the first anodic display electrode) including a transparent electrode layer, an organic functional layer, and a column electrode 15 (the second display electrode) including a metal electrode layer intersecting the row electrode. Each row electrode is formed in the shape of a stripe and disposed parallel to another at predetermined intervals and the column electrode is formed and disposed in the same manner as well. As described above, a display panel of a matrix type has an image display matrix made up of a plurality of organic EL elements formed at the intersections of a plurality of row and column electrodes. The first display electrode 13 can be made up of a metal bus line for electrically connecting island-shaped transparent electrodes in the horizontal direction. The organic EL display panel includes a plurality of barrier ribs 7 provided between organic EL elements on the film of silicon oxynitride on the resin substrate 10. The sealing film 16 is formed on top of the second display electrode 15 and the barrier rib 7. It is also possible to select and deposit an organic functional layer material as appropriate to form light-emitting portions such as red R, green G, and blue B portions.

Furthermore, the organic EL display panel may include an inorganic passivation film as part of the sealing film 16 for covering the organic EL element and the barrier rib 7 from the rear side thereof. As a barrier to moisture, a sealing film formed of resin can be provided on the inorganic passivation film. It is also possible to provide another inorganic passivation film formed of an inorganic substance on the outermost surface of the sealing film of resin. The inorganic passivation film is formed of nitride such as the aforementioned silicon oxynitride, silicon nitride etc. or an inorganic substance such as oxide, silicon oxide etc. or carbon. As the resin for forming the sealing film, employed are fluorine-based resin, silicon-based resin, or synthetic resin such as photo-resist or polyimide.

The organic EL display panels having this sealing structure were kept for 260 hours at the room temperature and at a high relative humidity in the presence of heat (60 °C, 95%), respectively. After the keeping, it was found that no cracks and peeling occurred in the sealing structure and the organic EL display panel still provided a stable light-emitting operation.

As described above, the inorganic barrier film covering the substrate prevents the entry of moisture from the side of the resin substrate of the organic EL element.

Although, in the aforementioned embodiments, the sputtering method was employed to deposit the inorganic barrier film for preventing the entry of moisture, the present invention is not limited thereto. The vapor phase epitaxial method such as the plasma CVD method or the vacuum evaporation method are usable in the invention.

Furthermore, in the aforementioned embodiment, such an organic EL display panel of a passive matrix display type has been described which includes the organic functional layer 14 or light-emitting portions disposed at the intersections of a plurality of transparent electrodes 13 on the transparent resin substrate 10 and the metal electrodes 15. However, according to the present invention, the inclusion-inorganic-barrier laminate is also applicable to the substrate of panels of an active matrix display type.

According to the invention, even if water enters at one point of exposed edge of the high-molecular compound film between the inorganic barrier films, the invasion path of water is shut out because of embedding of the high-molecular compound film within the inorganic barrier film. The present invention provides a sealing structure enough to prevent the entry of moisture or oxygen, thereby making it possible to provide a highly reliable organic EL element and a highly reliable organic EL display. In addition, the alternate multilayer of the inorganic barrier film and the high-molecular compound film reduces the adverse influence of water invasion, even if pinholes exist in the lowest inorganic barrier film, because a small amount of water enters therethrough and diffuse within the next high-molecular compound film, as well as at the next inorganic barrier film and one after another. This advantageous effect is remarkably promoted with multiple of the inorganic barrier film and the high-molecular compound film. Further, the high-molecular compound film functions as a buffer layer to prevent the generation of cracks in the multiple inorganic barrier films.

## Claims

1. An organic electroluminescent display panel comprising:
one or more organic electroluminescent elements each having first and second display electrodes and one or more organic functional layers of organic compounds sandwiched and layered between said first and second display electrodes, the organic functional layers including a light-emitting layer;
a resin substrate supporting the organic electroluminescent elements; and
an inclusion-inorganic-barrier laminate provided at least between said organic electroluminescent elements and said resin substrate and having a high-molecular compound layer in a form of being in contact with said organic electroluminescent elements.

2. An organic electroluminescent display panel according to claim 1, wherein said inclusion-inorganic-barrier laminate is made of silicon oxynitride.

3. An organic electroluminescent display panel according to claim 1 or 2, wherein said inclusion-inorganic-barrier laminate is formed by a sputter deposition process.

4. An organic electroluminescent display panel according to any one of claims 1-3, wherein said high-molecular compound film is formed by a photolithography process or a printing process.

5. An organic electroluminescent display panel according to any one of claims 1-4, further comprising a sealing film for covering said organic electroluminescent elements from a rear side thereof.

6. An organic electroluminescent display panel according to claim 5, wherein said sealing film is an inorganic passivation film, and said organic electroluminescent element is entirely and hermetically covered with said inclusion-inorganic-barrier laminate and said sealing film.

7. An organic electroluminescent display panel according to any one of claims 1-6, wherein said inclusion-inorganic-barrier laminate comprises one or more inorganic-barrier film pairs sandwiching said high-molecular compound film in a thickness direction thereof.

8. A method of manufacturing an organic electroluminescent display panel comprising one or more organic electroluminescent elements and a resin substrate supporting the organic electroluminescent elements, comprising the steps of:
forming a first inorganic barrier film having an area so as to cover the resin substrate;
forming, on or over said first inorganic barrier film, a high-molecular compound film having an area smaller than that of said first inorganic barrier film;
forming, on or over said high-molecular compound film, a second inorganic barrier film having an area larger than that of said high-molecular compound film;
forming, on or over said second inorganic barrier film, one or more organic electroluminescent elements, each having first and second display electrodes and one or more organic functional layers of organic compounds sandwiched and layered between said first and second display electrodes, the organic functional layers including a light-emitting layer.

9. An organic electroluminescent display panel according to claim 8, wherein said first and second inorganic barrier films are made of silicon oxynitride.

10. An organic electroluminescent display panel according to claim 8 or 9, wherein said first and second inorganic barrier films are formed by a sputter deposition process.

11. An organic electroluminescent display panel according to any one of claims 8-10, wherein said high-molecular compound film is formed by a photolithography process or a printing process.
